# EUROPÄISCHE PATENTSCHRIFT

(11) **EP 0 739 540 B1**
(45) Veröffentlichungstag und Bekanntmachung des Hinweises auf die Patenterteilung: **31.05.2000**
(21) Anmeldenummer: 95905535.1
(22) Anmeldetag: 12.01.1995
(51) Int. Cl.: H01L 21/822, H01L 27/06

(54) **VERFAHREN ZUR HERSTELLUNG EINER DREIDIMENSIONALEN SCHALTUNGSANORDNUNG**
PROCESS FOR PRODUCING A THREE-DIMENSIONAL CIRCUIT
PROCEDE DE FABRICATION D'UN CIRCUIT TRIDIMENSIONNEL

(30) Priorität: 14.01.1994 DE 4400985
(43) Veröffentlichungstag der Anmeldung: 30.10.1996
(73) Patentinhaber: SIEMENS AKTIENGESELLSCHAFT, 80333 München (DE)
(72) Erfinder: BERTAGNOLLI, Emmerich, D-80799 München (DE); KLOSE, Helmut, D-81929 München (DE)
(86) Internationale Anmeldenummer: DE9500031
(87) Internationale Veröffentlichungsnummer: WO9519642

(56) Entgegenhaltungen:
- PATENT ABSTRACTS OF JAPAN vol. 013 no. 002 (E-700) ,6.Januar 1989 & JP,A,63 213943 (SHARP CORP) 6.September 1988,
- PATENT ABSTRACTS OF JAPAN vol. 009 no. 008 (E-289) ,12.Januar 1985 & JP,A,59 155951 (FUJITSU KK) 5.September 1984,
- SYMPOSIUM ON VLSI TECHNOLOGY, HONOLULU, JUNE 4 - 7, 1990, Nr. SYMP. 10, INSTITUTE OF ELECTRICAL AND ELECTRONICS ENGINEERS, Seiten 95-96, XP 000164428 HAYASHI Y ET AL 'FABRICATION OF THREE-DIMENSIONAL IC USING "CUMULATIVELY BONDED IC" (CUBIC) TECHNOLOGY'

## Beschreibung

Die Erfindung betrifft ein Verfahren zur Herstellung einer dreidimensionalen Schaltungsanordnung gemäß dem Oberbegriff des Anspruchs 1.

In der Planartechnik, die heutzutage hauptsächlich für Halbleiterschaltungen eingesetzt wird, ist der erreichbare Integrationsgrad auf einem Chip einerseits durch die Größe des Chips und andererseits durch die erreichbare Strukturfeinheit begrenzt. Die Leistungsfähigkeit eines Systems, das in Planartechnik realisiert ist und das mehrere miteinander verbundene Chips umfaßt, ist durch die Zahl der möglichen Verbindungen zwischen einzelnen Chips über Anschlußkontakte, die erreichbare Geschwindigkeit der Signalübertragung über solche Verbindungen (die sogenannte Frequenzperformance) sowie durch den Leistungsverbrauch begrenzt.

Zur Überwindung dieser Beschränkungen ist vorgeschlagen worden (siehe zum Beispiel T. Kunio et al, IEDM '89, S. 837 oder K. Oyama et al, IEDM '90, S. 59) dreidimensionale Schaltungsanordnungen einzusetzen. Darin werden mehrere Chipebenen übereinander angeordnet. Die notwendigen elektrischen Verbindungen zwischen den Chipebenen werden über direkte Kontaktierungen erzeugt.

Zur Herstellung dreidimensionaler integrierter Schaltungen ist es bekannt (siehe zum Beispiel T. Kunio et al, IEDM '89, S. 837 oder K. Oyama et al, IEDM '90, S. 59), auf ein Substrat, in dem eine Ebene von Bauelementen hergestellt ist, eine weitere Halbleiterschicht abzuscheiden. Diese Halbleiterschicht wird zum Beispiel durch Laserausheilen rekristallisiert. In der rekristallisierten Schicht wird dann eine weitere Bauelementeebene realisiert. Die im Substrat vor der Abscheidung der weiteren Halbleiterschicht hergestellten Bauelemente sind bei der Rekristallisation der damit verbundenen thermischen Belastung ausgesetzt, die durch hohe Defektzahlen zu sehr begrenzter Ausbeute führt.

Aus Y. Hayashi et al, Symp. VLSI Technol. 1990, S. 95 ist bekannt, zur Herstellung einer dreidimensionalen integrierten Schaltungsanordnung zunächst die einzelnen Bauelementeebenen getrennt voneinander in verschiedenen Substraten herzustellen. Diese Substrate werden dann auf wenige µm gedünnt und mit Hilfe des Wafer-Bonding-Verfahrens miteinander verbunden. Zur elektrischen Verbindung der verschiedenen Bauelementeebenen werden die gedünnten Substrate auf der Vorder- und Rückseite mit Kontakten zur Interchip-Verbindung versehen. Das hat den Nachteil, daß die gedünnten Scheiben auf der Vorder- und der Rückseite bearbeitet werden müssen. Rückseitenprozesse sind in der Standardplanartechnik nicht vorgesehen. In diesem Zusammenhang sind eine Reihe von Handlingproblemen ungelöst. Ein weiterer Nachteil des bekannten Verfahrens ist darin zu sehen, daß die Funktionstüchtigkeit der einzelnen Bauelementeebenen vor dem Zusammenfügen nicht ohne weiteres zu testen ist, da in jeder einzelnen Ebene einzelne Bauelemente, aber keine vollständigen Schaltungen realisiert werden.

In beiden bekannten Verfahren werden Bauelemente und die dreidimensionale Schaltungsanordnung im wesentlichen gleichzeitig hergestellt, so daß das Verfahren bei einem Chiphersteller durchgeführt werden muß.

Ein Verfahren mit den Merkmalen des Oberbegriffs des Anspruchs 1 in aus JP 63213943 A bekannt. Dabei werden zu Herstellung einen dreidimensionalen Schaltungsanordnung speziell praparierte Substrate übereinander angeordnet und miteinander befestigt.

Dazu werden zuerst in den einzelnen Substraten tiefe Kontaktlöcher geöffnet, die mit einer isolierenden Füllung aufgefüllt werden. Anschließend werden die Substrate von der Rückseite her durch Schleifen oder Ätzen gedünnt, bis der Boden der tiefen Kontaktlöcher erreicht ist. Dabei wird am Boden des tiefen Kontaktloches die Oberfläche der isolierenden Füllung freigelegt. Anschließend wird das in dieser Form vorbereitete Substrat mit Hilfe einer Polyimidschicht auf einem zweiten Substrat befestigt. Das tiefreichende Kontaktloch wird dabei so angeordnet, daß es auf eine Metallisierungsebene des zweiten Substrates reicht. Anschließend wird die isolierende Füllung aus dem tiefreichenden Kontaktloch entfernt. Ferner wird im Bereich des Kontaktloches die Polyimidschicht und eine etwaige darunterliegende Passivierungsschicht durchätzt. Nachfolgend wird das Kontaktloch mit leitendem Material gefüllt. Über dieses tiefreichende Kontaktloch werden elektrische Verbindungen zwischen Bauelementen im oberen und im unteren Substrat realisiert.

Der Erfindung liegt das Problem zugrunde, ein Verfahren zur Herstellung einer dreidimensionalen Schaltungsanordnung anzugeben, bei dem die Herstellung einzelner Bauelemente unabhängig vom Aufbau der dreidimensionalen Schaltungsanordnung erfolgen kann.

Dieses Problem wird erfindungsgemäß gelöst durch ein Verfahren nach Anspruch 1. Weitere Ausgestaltungen der Erfindung gehen aus den übrigen Ansprüchen hervor.

In dem erfindungsgemäßen Verfahren werden zwei fertig prozessierte Substrate, die jeweils Schaltungsstrukturen und Metallisierungsebenen umfassen, über eine Haftschicht miteinander verbunden. Das obere Substrat wird dabei zuvor von der Rückseite her gedünnt. Von der Oberfläche des oberen Substrats aus werden Kontaktlöcher auf eine Metallisierungsebene des oberen Substrats und eine Metallisierungsebene des unteren Substrats geöffnet. Das Kontaktloch, das auf die Metallisierungsebene des unteren Substrates reicht, durchquert dabei das obere Substrat vollständig. Anschließend wird auf die Oberfläche des oberen Substrats eine leitfähige Schicht aufgebracht, die über die Kontaktlöcher eine elektrische Verbindung zwischen den Metallisierungsebenen der beiden Substrate herstellt.

Als Substrate sind monokristalline Siliziumsubstrate, SOI-Substrate oder Substrate verschiedener Technologiefamilien, wie zum Beispiel III-V-Halbleiter, geeignet. Als Substrat ist ebenfalls eine nach dem erfindungsgemäßen Verfahren hergestellte Doppel- oder allgemein Vielfach-Struktur geeignet, so daß das erfindungsgemäße Verfahren zur Herstellung einer dreidimensionalen Schaltungsanordnung mit beliebig vielen Bauelementeebenen geeignet ist. Die Verwendung eines SOI-Substrates als oberes Substrat hat den Vorteil, daß beim Dünnen des oberen Substrates die vergrabene Oxidschicht des SOI-Substrates als Stopschicht verwendet werden kann.

Als Haftschicht zur festen Verbindung zwischen benachbarten Substraten ist zum Beispiel ein Polyimid geeignet, das durch eine Polymerisierung ausgehärtet wird.

Abgesehen von dem Dünnen des jeweils oberen Substrates und dem Zusammenfügen der Substrate werden in dem erfindungsgemäßen Verfahren nur aus der Planartechnik bekannte und eingeführte Prozeßschritte verwendet. Da auf exotische Prozeßschritte verzichtet wird, werden mit dem erfindungsgemäßen Verfahren große Ausbeuten erzielt.

Zur Justierung der Substrate gegeneinander bei dem Zusammenfügen der Substrate liegt es im Rahmen der Erfindung, die Substrate jeweils mit Justiermarken zu versehen, über die im infraroten Durchlicht eine Justierung erfolgt.

Es liegt im Rahmen der Erfindung, auf die leitfähige Schicht ganzflächig eine weitere Passivierungsschicht aufzubringen, in der Anschlußöffnungen zu den Metallisierungsebenen der Substrate und/oder der leitfähigen Schicht und/oder zu weiteren leitfähigen Strukturen oder Metallisierungsebenen in den Substraten geöffnet werden können, je nach Anforderung der Anwendung.

Die Herstellung des Kontaktloches auf die Metallisierungsebene des unteren Substrates erfordert in der Praxis eine Ätzung in eine Tiefe, die viel größer ist als der Durchmesser des Kontaktloches. Dazu sind insbesondere anisotrope Ätzprozesse in CHF₃- und HBr-Plasmen geeignet.

Im folgenden wird die Erfindung anhand der Figuren und eines Ausführungsbeispiels näher erläutert.
- Figur 1: zeigt ein erstes Substrat mit Schaltungsstrukturen und Metallisierungsebenen.
- Figur 2: zeigt das erste Substrat mit einer ersten Haftschicht und einem Hilfssubstrat.
- Figur 3: zeigt ein zweites Substrat mit Schaltungsstrukturen und Metallisierungsebenen.
- Figur 4: zeigt das zweite Substrat mit einer zweiten Haftschicht.
- Figur 5: zeigt das erste Substrat und das zweite Substrat nach dem Dünnschleifen des ersten Substrates und dem Zusammenfügen beider Substrate.
- Figur 6: zeigt das erste Substrat und das zweite Substrat nach dem Öffnen eines zweiten Kontaktloches, das bis auf eine Metallisierungsebene des zweiten Substrates reicht.
- Figur 7: zeigt das erste Substrat und das zweite Substrat nach der Herstellung von Flankenisolationen und der Erzeugung einer leitfähigen Schicht.
- Figur 8: zeigt das erste Substrat und das zweite Substrat mit einem auf eine Metallisierungsebene des zweiten Substrates reichenden zweiten Kontaktloch, das in einem anisotropen Ätzprozeß geöffnet wurde.

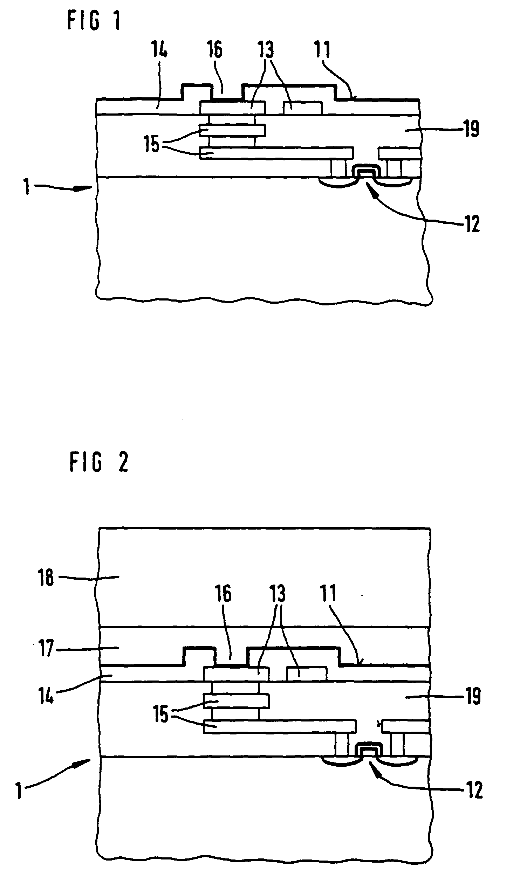

Ein erstes Substrat 1 aus zum Beispiel monokristallinem Silizium umfaßt im Bereich einer ersten Hauptfläche 11 eine erste Schaltungsstruktur 12, zum Beispiel einen MOS-Transistor und eine erste Metallisierungsebene 13. Die erste Metallisierungsebene 13 ist von einer ersten Passivierungsschicht 14 aus zum Beispiel SiO₂/Si₃N₄ bedeckt. Unterhalb der ersten Metallisierungsebene 13 umfaßt das erste Substrat 1 weitere Metallisierungsebenen 15, die von einer Oxidschicht 19 umgeben sind. Die erste Metallisierungsebene 13 besteht zum Beispiel aus Aluminium oder einer Aluminiumlegierung. Unterhalb der ersten Schaltungsstruktur 12 weist das erste Substrat 1 senkrecht zur ersten Hauptfläche 11 eine Ausdehnung von zum Beispiel 625 µm auf. In der ersten Passivierungsschicht 14 ist ein erstes Kantaktloch 16 geöffnet, das auf die Oberfläche der ersten Metallisierungsebene 13 reicht (siehe Figur 1).

Auf die erste Hauptfläche 11, das heißt auf die Oberfläche der ersten Passivierungsschicht 14, wird ganzflächig eine erste Haftschicht 17 aus zum Beispiel Polyimid oder Polyacrylat aufgebracht. Die erste Haftschicht 17 wird in einer Dicke von zum Beispiel 1,5 µm aufgebracht. Auf die erste Haftschicht 17 wird ein Hilfssubstrat 18 aufgeklebt. Als Hilfssubstrat 18 ist zum Beispiel ein Si-Wafer geeignet. Das Hilfssubstrat 18 wird als Handling-Wafer oder Handling-Chip verwendet und schützt die erste Hauptfläche 11 bei der weiteren Prozessierung des ersten Substrates (siehe Figur 2).

Durch Dünnschleifen oder Dünnätzen wird das erste Substrat 1 von einer zweiten Hauptfläche, die der ersten Hauptfläche 11 gegenüberliegt, her gedünnt, bis die Dicke des Substrats senkrecht zur ersten Hauptfläche 11 unterhalb der Schaltungsstruktur 12 eine Restdicke von einigen µm, vorzugsweise 5 µm aufweist.

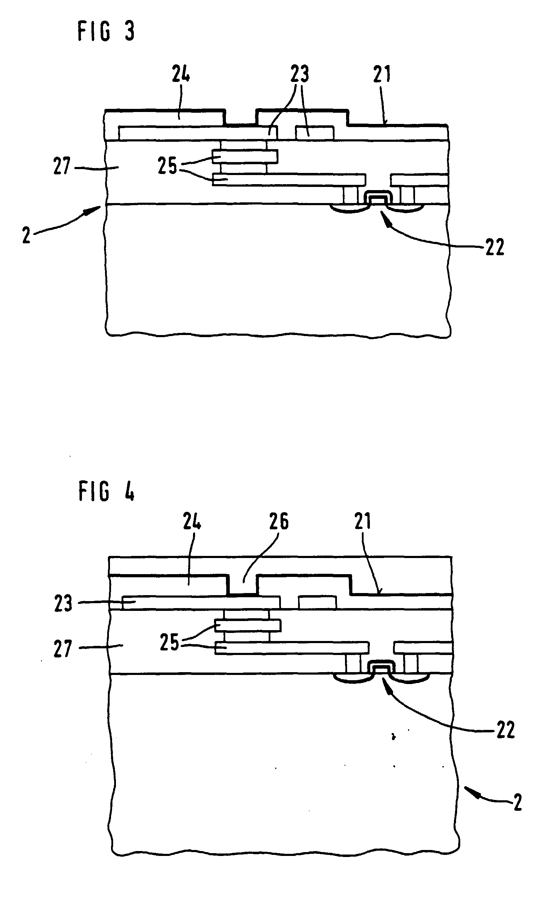

Ein zweites Substrat 2 besteht zum Beispiel aus monokristallinem Silizium und umfaßt im Bereich einer dritten Hauptfläche 21 mindestens eine Schaltungsstruktur 22, zum Beispiel einen MOS-Transistor, und eine zweite Metallisierungsebene 23. Die zweite Metallisierungsebene 23 ist von einer Passivierungsschicht aus zum Beispiel SiO₂/Si₃N₄ bedeckt. Unterhalb der zweiten Metallisierungsebene umfaßt das Substrat 2 weitere Metallisierungsebenen 25, die zum Beispiel von einer Oxidschicht 27 umgeben sind. Die zweite Metallisierungsebene 23 besteht zum Beispiel aus Aluminium oder einer Aluminiumlegierung (siehe Figur 3).

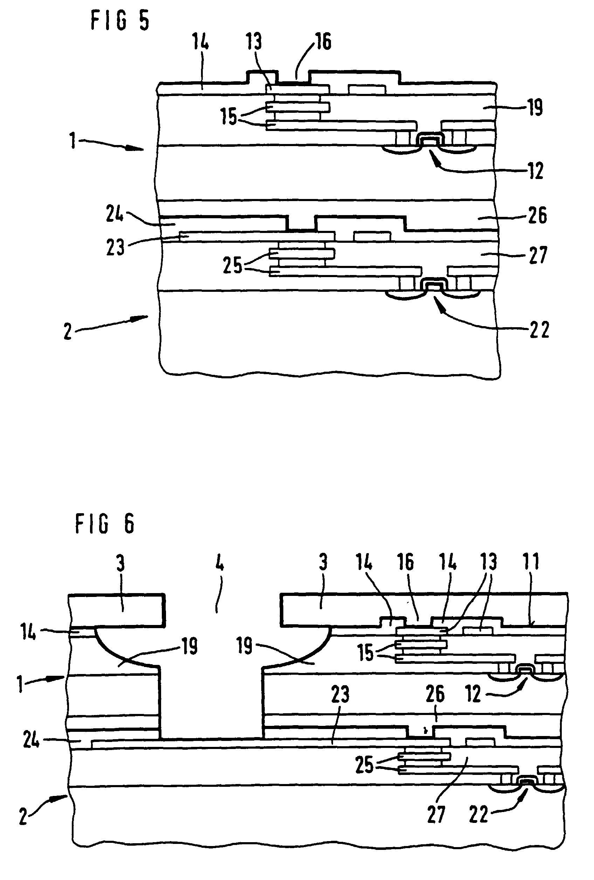

Auf die dritte Hauptfläche 21, das heißt auf die Oberfläche der zweiten Passivierungsschicht 24 wird ganzflächig eine zweite Haftschicht aus zum Beispiel Polyimid aufgebracht (siehe Figur 4). Anschließend wird das gedünnte erste Substrat 1 mit dem zweiten Substrat 2 zusammengefügt. Dabei wird die der ersten Hauptfläche 11 gegenüberliegende zweite Hauptfläche auf die Oberfläche der zweiten Haftschicht 26 aufgebracht. Die genaue gegenseitige Justierung des ersten Substrats 1 und des zweiten Substrats 2 erfolgt vorzugsweise über Justiermarken auf dem ersten Substrat 1 und dem zweiten Substrat 2 (nicht dargestellt) im infraroten Durchlicht (siehe Figur 5). Nach dem Zusammenfügen des ersten Substrats 1 und des zweiten Substrats 2 wird die zweite Haftschicht 26 nachbehandelt, so daß eine feste Verbindung zwischen dem ersten Substrat 1 und dem zweiten Substrat 2 entsteht. Die Nachbehandlung besteht zum Beispiel in der Polymerisation des Polyimids.

Anschließend wird das Hilfssubstrat 18 zum Beispiel durch Abätzen entfernt. Die dann freiliegende erste Haftschicht 17 wird zum Beispiel mit einem Sauerstoffplasma oder einem Lösungsmittel ganzflächig entfernt. Dabei wird auch das erste Kontaktloch 16 zu der ersten Metallisierungsebene 13 in der ersten Passivierungsschicht 14 geöffnet.

Es wird eine Photolackmaske 3 erzeugt, die die Lage eines zweiten Kontaktloches 4 definiert. In einem kombinierten Ätzprozeß wird dann das zweite Kantaktloch 4 geöffnet. Dazu wird zunächst in einem isotropen Ätzprozeß mit zum Beispiel HNO₃/HF die erste Passivierungsschicht 14 und die die weitere Metallisierungsebenen 15 umgebende Oxidschicht 19 geätzt. In einem anisotropen Ätzverfahren, zum Beispiel in einem HBr-Plasma wird dann das Silizium des ersten Substrates 1, die zweite Haftschicht 26 und die zweite Passivierungsschicht 24 durchätzt, bis das zweite Kontaktloch 4 bis auf die zweite Metallisierungsebene 23 reicht (siehe Figur 6).

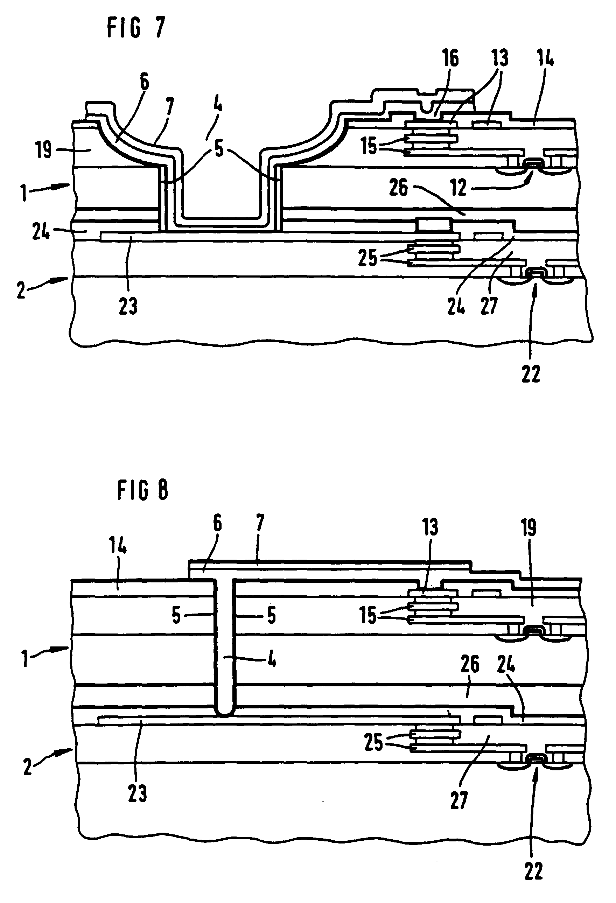

Nach Entfernung der Photolackmaske 3 und entsprechenden Reinigungsschritten wird eine isolierende Schicht mit im wesentlichen konformer Kantenbedeckung, zum Beispiel ein Oxid, abgeschieden. Aus der isolierenden Schicht wird mit Hilfe einer weiteren Phototechnik oder vorzugsweise selbstjustierend über eine Spacertechnik eine Flankenisolation 5 erzeugt, die das freiliegende Silizium an den Seitenwänden des zweiten Kontaktloches 4 abdeckt (siehe Figur 7).

Dann wird eine Diffusionsbarriereschicht 6 aus zum Beispiel Ti/TiN und darauf eine leitfähige Schicht 7 aus zum Beispiel Aluminium oder CVD-Wolfram aufgebracht. Die leitfähige Schicht 7 und die Diffusionsbarriereschicht 6, die ebenfalls leitfähig ist, bedecken sowohl die im zweiten Kontaktloch 4 freiliegende Oberfläche der zweiten Metallisierungsebene 23 als auch die im ersten Kantaktloch 16 freiliegende Oberfläche der ersten Metallisierungsebene 13. Über die Diffusionebarriere 6 und die leitfähige Schicht 7 sind daher die erste Metallisierungsebene 13 und die zweite Metallisierungsebene 23 elektrisch miteinander verbunden. Nachfolgend werden die Diffusionsbarriereschicht 6 und die leitfähige Schicht 7 strukturiert. Die strukturierte leitfähige Schicht 7 stellt eine vertikale elektrische Verbindung zwischen dem ersten Substrat 1 und dem, zweiten Substrat 2 dar (siehe Figur 7).

Abschließend wird auf die Struktur noch eine weitere Passivierungsschicht aus zum Beispiel SiO₂ aufgebracht, in der Anschlußflächen (Bondflächen) zu der leitfähigen Schicht 7 und/oder anderen Metallisierungsebenen geöffnet werden.

Durch die Verwendung eines isotropen Ätzprozesses zur Ätzung der ersten Passivierungsschicht 14 und der Oxidschicht 19 kommt es zu einem relativ großen Querschnitt des zweiten Kontaktloches 4. Diese Ausführungsform der Erfindung ist daher für ein relativ grobes Verdrahtungsraster geeignet.

Alternativ kann ausgehend von der in Figur 5 gezeigten Struktur das zweite Kantaktloch 4 in einem anisotropen Ätzprozeß gebildet werden. Vorzugsweise erfolgt die Ätzung mit Hilfe eines CHF₃ und HBr-Plasma. In diesem Fall wird das Kontaktloch 4 mit einem viel extremeren Aspektverhältnis (das ist das Verhältnis vor Querschnitt zur Tiefe des Kontaktloches) gebildet (siehe Figur 8). In diesem Ätzprozeß können Aspektverhältnisse bis zu 1 .. 20 erzielt werden. Diese Ausführungsform der Erfindung wird vorzugsweise für feine Verdrahtungsraster eingesetzt. Auch in dieser Ausführungsform der Erfindung werden Flankenisolationen 5 entlang den Seitenwänden des zweiten Kontaktloches 4 erzeugt. Dazu wird zum Beispiel in einem Ozon-TEOS-Verfahren eine SiO₂-Schicht mit im wesentlichen konformer Kantenbedeckung abgeschieden und anschließend anisotrop geätzt, bis die Oberfläche der zweiten Metallisierungsebene 23 freigelegt ist. Anschließend wird das zweite Kontaktloch mit der Diffusionsbarriereschicht 6 und der leitfähigen Schicht 7 aufgefüllt (siehe Figur 8). In diesem Fall werden die Diffusionsbarriereschicht 6 und die leitfähige Schicht 7 aus zum Beispiel CVD-TiN und CVD-W gebildet.

Das erste Kontaktloch 16 kann vor dem Zusammenfügen des ersten Substrats 1 mit dem zweiten Substrat 2, wie in dem Ausführungsbeispiel beschrieben, oder nach dem Zusammenfügen des ersten Substrats 1 und des zweiten Substrats 2 geöffnet werden. Das erste Kontaktloch 16, das auf die erste Metallisierungsebene 13 reicht, muß vor der Abscheidung der Diffusionsbarriereschicht 6 und der leitfähigen Schicht 7 geöffnet werden.

## Patentansprüche

1. Verfahren zur Herstellung einer dreidimensionalen Schaltungsanordnung,
- bei dem ein erstes Substrat (1), das im Bereich einer ersten Hauptfläche (11) mindestens eine erste Schaltungsstruktur (12), umfaßt auf der eine erste Metallisierungsebene (13) und eine die erste Metallisierungsebene (13) bedeckende erste Passivierungsschicht (14) vorgesehen sind, über eine erste Haftschicht (17), die auf die erste Passivierungsschicht (14) aufgebracht wird, mit einem Hilfssubstrat (18) verbunden wird,
- bei dem das mit dem Hilfssubstrat (18) verbundene erste Substrat (1) an einer zweiten Hauptfläche, die der ersten Hauptfläche (11) gegenüberliegt, gedünnt wird,
- bei dem ein zweites Substrat (2), das im Bereich einer dritten Hauptfläche (21) mindestens eine zweite Schaltungsstruktur (22) umfaßt, auf der eine zweite Metallisierungsebene (23) und eine die zweite Metallisierungsebene (23) bedeckende zweite Passivierungsschicht (24) vorgesehen sind, auf der zweiten Passivierungsschicht (24) mit einer zweiten Haftschicht (26) versehen wird,
- bei dem nach dem Dünnen des ersten Substrats (1) das erste Substrat (1) und das zweite Substrat (2) so zusammengefügt werden, daß die zweite Hauptfläche des ersten Substrats (1) an die zweite Haftschicht (24) auf dem zweiten Substrat (2) angrenzt und daß das erste Substrat (1) und das zweite Substrat (2) über die zweite Haftschicht (26) fest verbunden sind,
- bei dem nach dem Verbinden des ersten Substrats (1) mit dem zweiten Substrat (2) das Hilfssubstrat (18) und die erste Haftschicht (17) entfernt werden,
- bei dem nach Entfernen des Hilfssubstrats (18) und der ersten Haftschicht (17) ausgehend von der ersten Passivierungsschicht (14) mindestens ein zweites Kantaktloch (4) zu der zweiten Metallisierungsebene (23) geöffnet wird,
- bei dem auf der ersten Passivierungsschicht (14) eine leitfähige Schicht (7) erzeugt wird, die die erste Metallisierungsebene (13) und die zweite Metallisierungsebene (23) elektrisch miteinander verbindet,
- bei dem vor der Bildung der leitfähigen Schicht (7) ausgehend von der ersten Passivierungsschicht (14) ein erstes Kontaktloch (16) auf die erste Metallisierungsebene (13) geöffnet wird, dadurch gekennzeichnet, daß
- beim Öffnen des zweiten Kontaktlochs (4) mindestens das erste Substrat (1) geätzt wird.

2. Verfahren nach Anspruch 1,
bei dem vor Erzeugen der leitfähigen Schicht (7) an den Seitenwänden mindestens des zweiten Kontaktloches (4) Flankenisolationen (5) erzeugt werden.

3. Verfahren nach Anspruch 1 oder 2,
bei dem das erste Substrat (1) und das zweite Substrat (2) jeweils mit Justiermarken versehen sind, über die beim Zusammenfügen des ersten Substrats (1) und des zweiten Substrats (2) im infraroten Durchlicht eine Justierung erzeugt.

4. Verfahren nach einem der Ansprüche 1 bis 3,
bei dem das Dünnen des ersten Substrats (1) durch Dünnschleifen und/oder Dünnätzen erfolgt.

5. Verfahren nach Anspruch 4,
- bei dem mindestens das erste Substrat (1) ein SOI-Substrat ist, das eine einkristalline Siliziumschicht, eine vergrabene SiO₂-Schicht und eine Siliziumscheibe umfaßt,
- bei dem beim Dünnen des ersten Substrats die Siliziumscheibe entfernt wird,
- bei dem die erste Schaltungsstruktur (12) in der einkristallinen Siliziumschicht des SOI-Substrats realisiert ist.

6. Verfahren nach einem der Ansprüche 1 bis 5,
bei dem auf die leitfähige Schicht (7) ganzflächig eine weitere Passivierungsschicht aufgebracht wird.

7. Verfahren nach einem der Ansprüche 1 bis 6,
bei dem im ersten Substrat (1) unterhalb der ersten Metallisierungsebene (13) und/oder im zweiten Substrat (2) unterhalb der zweiten Metallisierungsebene (23) weitere Metallisierungsebenen (15, 25) angeordnet sind.

8. Verfahren nach einem der Ansprüche 1 bis 7,
bei dem die erste Haftschicht (17) aus einem Polyimid oder einem Polyacrylat gebildet wird und mit Hilfe von O₂-Plasmen oder naßchemisch entfernt wird.

9. Verfahren nach einem der Ansprüche 1 bis 8,
bei dem die zweite Haftschicht (26) aus einem Polyimid gebildet wird, das nach dem Zusammenfügen des ersten Substrates (1) und des zweiten Substrates (2) durch Polymerisation ausgehärtet wird.

10. Verfahren nach einem der Ansprüche 1 bis 9,
bei dem die Öffnung des zweiten Kontaktloches (4) in einer kombinierten Ätzung erfolgt, die mindestens eine isotrope Ätzung mit HNO₃/HF und eine anisotrope Ätzung in einem HBr-Plasma umfaßt.

11. Verfahren nach einem der Ansprüche 1 bis 9,
bei dem die Öffnung des zweiten Kontaktloches (4) in einer anisotropen Ätzung in CHF₃- und HBr-Plasmen erfolgt.

## Claims

1. Method for the production of a three-dimensional circuit arrangement,
- in which a first substrate (1), which comprises, in the region of a first main area (11), at least one first circuit structure (12) on which a first metallization plane (13) and a first passivation layer (14) which covers the first metallization plane (13) are provided, is connected to an auxiliary substrate (18) via a first adhesion layer (17) which is applied to the first passivation layer (14),
- in which the first substrate (1), which is connected to the auxiliary substrate (18), is thinned at a second main area opposite to the first main area (11),
- in which a second substrate (2), which comprises, in the region of a third main area (21), at least one second circuit structure (22) on which a second metallization plane (23) and a second passivation layer (24) which covers the second metallization plane (23) are provided, is provided with a second adhesion layer (26) on the second passivation layer (24),
- in which, after the first substrate (1) is thinned, the first substrate (1) and the second substrate (2) are joined together in such a way that the second main area of the first substrate (1) adjoins the second adhesion layer (26) on the second substrate (2), and that the first substrate (1) and the second substrate (2) are fixedly connected via the second adhesion layer (26),
- in which, after the first substrate (1) has been connected to the second substrate (2), the auxiliary substrate (18) and the first adhesion layer (17) are removed,
- in which, after the removal of the auxiliary substrate (18) and of the first adhesion layer (17), at least one second contact hole (4) is opened to the second metallization plane (23) starting from the passivation layer (14),
- in which a conductive layer (7) is produced on the first passivation layer (14) and electrically connects the first metallization plane (13) and the second metallization plane (23) to one another,
- in which, prior to the formation of the conductive layer (7), a first contact hole (16) is opened to the first metallization plane (13) starting from the first passivation layer (14),
characterized in that
- during the opening of the second contact hole (4), at least the first substrate (1) is etched.

2. Method according to Claim 1,
in which side insulation (5) is produced on the side walls of at least the second contact hole (4) prior to the production of the conductive layer (7).

3. Method according to Claim 1 or 2,
in which the first substrate (1) and the second substrate (2) are each provided with alignment marks which are used to effect alignment using infrared transmitted light when the first substrate (1) and the second substrate (2) are joined together.

4. Method according to one of Claims 1 to 3,
in which the first substrate (1) is thinned by grinding and/or etching.

5. Method according to Claim 4,
- in which at least the first substrate (1) is an SOI substrate which comprises a monocrystalline silicon layer, a buried SiO₂ layer and a silicon wafer,
- in which the silicon wafer is removed during the thinning of the first substrate,
- in which the first circuit structure (12) is realized in the monocrystalline silicon layer of the SOI substrate.

6. Method according to one of Claims 1 to 5,
in which a further passivation layer is applied to the whole area of the conductive layer (7).

7. Method according to one of Claims 1 to 6,
in which further metallization planes (15, 25) are arranged in the first substrate (1), under the first metallization plane (13), and/or in the second substrate (2), under the second metallization plane (23).

8. Method according to one of Claims 1 to 7,
in which the first adhesion layer (17) is formed from a polyimide or a polyacrylate and is removed with the aid of O₂ plasmas or by wet-chemical means.

9. Method according to one of Claims 1 to 8,
in which the second adhesion layer (26) is formed from a polyimide which is cured by polymerization after the first substrate (1) and the second substrate (2) have been joined together.

10. Method according to one of Claims 1 to 9,
in which the second contact hole (4) is opened using combined etching which comprises at least isotropic etching using HNO₃/HF and anisotropic etching using an HBr plasma.

11. Method according to one of Claims 1 to 9,
in which the second contact hole (4) is opened using anisotropic etching using CHF₃ and HBr plasmas.

## Revendications

1. Procédé de fabrication d'un circuit tridimensionnel,
- dans lequel un premier substrat (1) comprenant au niveau d'une première surface principale (11) au moins une première structure de circuit (12), sur laquelle une première couche de métallisation (13) et une première couche de passivation (14) couvrant la première couche de métallisation (13) sont prévues, est relié, par l'intermédiaire d'une première couche adhésive (17) déposée sur ta première couche de passivation (14), à un substrat auxiliaire (18),
- dans lequel le premier substrat (1) relié au substrat auxiliaire (18) est aminci au niveau d'une deuxième surface principale opposée à la première surface principale (11),
- dans lequel un deuxième substrat (2) comprenant au niveau d'une troisième surface principale (21) au moins une deuxième structure de circuit (22), sur laquelle une deuxième couche de métallisation (23) et une deuxième couche de passivation (24) couvrant la deuxième couche de métallisation (23) sont prévues, est relié sur la deuxième couche de passivation (24) à une deuxième couche adhésive (26),
- dans lequel, après amincissement du premier substrat (1), le premier substrat (1) et le deuxième substrat (2) sont assemblés de façon telle que la deuxième surface principale du premier substrat (1) soit adjacente à la deuxième couche adhésive (24) sur le deuxième substrat (2) et que le premier substrat (1) et le deuxième substrat (2) soient solidement reliés par la deuxième couche adhésive (26),
- dans lequel, après liaison du premier substrat (1) avec le deuxième substrat (2), le substrat auxiliaire (18) et la première couche adhésive (17) sont supprimés,
- dans lequel, après suppression du substrat auxiliaire (18) et de la première couche adhésive (17), au moins un deuxième trou de contact (4) vers la deuxième couche de métallisation (23) est réalisé à partir de la première couche de passivation (14),
- dans lequel une couche conductrice (7) est formée sur la première couche de passivation (14), qui relie électriquement entre elles la première couche de métallisation (13) et la deuxième couche de métallisation (23),
- dans lequel, avant formation de la couche conductrice (7), un premier trou de contact (16) vers la première couche de métallisation (13) est ouvert à partir de la première couche de passivation (14),
caractérisé en ce que
- à la réalisation du deuxième trou de contact (4), au moins le premier substrat (1) subit une attaque chimique.

2. Procédé selon la revendication 1, dans lequel, avant la formation de la couche conductrice (7), des isolations de bord (5) sont réalisées aux parois latérales au moins du deuxième trou de contact (4).

3. Procédé selon la revendication 1 ou 2, dans lequel le premier substrat (1) et le deuxième substrat (2) sont munis à chaque fois de repères d'ajustage permettant à l'assemblage du premier substrat (1) et du deuxième substrat (2), un ajustage par transmission de lumière infrarouge.

4. Procédé selon l'une des revendications 1 à 3, dans lequel l'amincissement du premier substrat (1) est réalisé par rectification et/ou attaque chimique.

5. Procédé selon la revendication 4,
- dans lequel au moins le premier substrat (1) est un substrat SOI comprenant une couche monocristalline de silicium, une couche de SiO₂ enfouie et une tranche de silicium,
- dans lequel, lors de l'amincissement du premier substrat, la tranche de silicium est supprimée,
- dans lequel la première structure de circuit (12) est réalisée dans la couche monocristalline de silicium du substrat SOI.

6. Procédé selon l'une des revendications 1 à 5, dans lequel une autre couche de passivation est déposée sur toute la surface de la couche conductrice (7).

7. Procédé selon l'une des revendications 1 à 6, dans lequel d'autres couches de métallisation (15, 25) sont disposées dans le premier substrat (1) au-dessous de la première couche de métallisation (13) et/ou dans le deuxième substrat au-dessous de la deuxième couche de métallisation (23).

8. Procédé selon l'une des revendications 1 à 7, dans lequel la première couche adhésive (17) est formée à partir d'un polyimide ou d'un polyacrylate et supprimée à l'aide de plasmas O₂ ou d'un traitement chimique par voie humide.

9. Procédé selon l'une des revendications 1 à 8, dans lequel la deuxième couche adhésive (26) est formée à partir d'un polyimide qui après assemblage du premier substrat (1) et du deuxième substrat (2), est durci par polymérisation.

10. Procédé selon l'une des revendications 1 à 9, dans lequel la réalisation du deuxième trou de contact (4) se fait par attaque chimique combinée comprenant au moins une attaque chimique isotrope avec du HNO₃/HF et une attaque chimique anisotrope dans un plasma HBr.

11. Procédé selon l'une des revendications 1 à 9, dans lequel la réalisation du deuxième trou de contact (4) se fait par attaque chimique anisotrope dans des plasmas CHF₃ et HBr.
